# EUROPEAN PATENT APPLICATION

(11) **EP 4 607 212 A1**
(43) Date of publication of application: **27.08.2025**
(21) Application number: 24159064.5
(22) Date of filing: 22.02.2024
(51) Int. Cl.: G01R 31/12, G01R 31/16, G01R 31/385, H01M 10/42, H01M 10/48

(54) **TEST DEVICE AND TEST SYSTEM FOR EVALUATING AN ELECTRIC ARCING PROPERTY OF A TRACTION BATTERY OF A VEHICLE, USE, AND METHOD**

(71) Applicant: Volvo Car Corporation, 405 31 Göteborg (SE)
(72) Inventor: WERBERG, Leopold, 40531 Göteborg (SE); MYSORE, Nandeep, 40531 Göteborg (SE)
(74) Representative: Maiwald GmbH

(57) **Abstract**

The disclosure relates to a test device (22) for evaluating an electric arcing property of a traction battery (12) of a vehicle. The test device (22) comprises an electrically nonconductive or electrically insulated holder (30), a first electrode, and a second electrode. The first electrode has a first end and a second end. The second electrode has a first end and a second end. The first electrode and the second electrode are supported on the holder (30) such that the first ends form a gap between each other. Additionally, a test system (14) for evaluating an electric arcing property of a traction battery (12) of a vehicle is described. The test system (14) comprises such a test device (22), an electric source (24), and an electric monitoring unit (26). Furthermore, a use of a test device (22) and/or a use of a test system (14) are shown. Additionally, a method for evaluating an electric arcing property of a traction battery (12) of a vehicle is presented.

## Description

### TECHNICAL FIELD

The present disclosure relates to a test device for evaluating an electric arcing property.

Moreover, the present disclosure is directed to a test system for evaluating an electric arcing property.

Additionally, the present disclosure relates to a use of a test device and/or a test system.

Furthermore, the present disclosure is directed to a method for evaluating an electric arcing property.

### BACKGROUND ART

Battery Electric Vehicles (BEV) and their drive trains are powered by a traction battery. Traction batteries commonly comprise an array of battery cells that are connected either in series, in parallel or in a combination of both in order to reach a desired system output voltage window that is suitable for an associated motor and drive train. Battery cells exist in different formats, such as cylindrical, prismatic or pouch-shaped and generate heat due to internal resistance when electric power is drawn from the battery (acceleration of the associated vehicle) or applied (charging of the battery). Heat that is generated may increase the battery cell temperature.

For such batteries, a known error is a so-called thermal event. A thermal event usually includes an undesired chemical reaction within at least one battery cell of the battery and may involve an ejection of electrically conductive matter from the battery cell, e.g. gaseous and/or liquid electrolyte and particles. Electrically conductive matter ejected from a cell may alter the electric resistance of an atmosphere within the traction battery. This may negatively affect electric isolation within the traction battery and cause a risk of electric arcing.

Such electric arcing may lead to serious damages to the whole traction battery and therefore to the whole BEV. Furthermore, the passenger safety may be affected. Thus, electric arcing is to be avoided and, therefore, may be tested during development of batteries.

Common test assemblies for determining the risk of electrical arcing during ongoing thermal events require large space and involve cost effective instrumented battery packs. These test assemblies are often destructed during the test. The electrical arc that is created in these test assemblies destroys relatively large amounts of material in a relatively short amount of time, making it difficult to find the starting point of the electrical arc. Therefore, test results are often difficult to interpret since the damage that occurs to the test assemblies is often uncontrolled spread across the components.

### SUMMARY

It is therefore an objective of the present disclosure to improve test devices for an evaluation of an electric arcing property of a traction battery of a vehicle.

The problem is at least partially solved or alleviated by the subject matter of the independent claims of the present disclosure, wherein further examples are incorporated in the dependent claims.

According to a first aspect, there is provided a test device for evaluating an electric arcing property of a traction battery of a vehicle. The test device comprises an electrically non-conductive or electrically insulated holder, a first electrode having a first end and a second end, and a second electrode having a first end and a second end. The first electrode and the second electrode are supported on the holder such that the first end of the first electrode and the first end of the second electrode form a gap between each other. The non-conductive or electrically insulated property of the holder may be achieved by using materials with these properties as holder and/or coating and/or alike. In contrast thereto, the first electrode and the second electrode are configured to conduct an electric current. To this end, the first electrode and the second electrode may be made of an electrically conductive material. The first end and the second end of the first electrode are opposite to one another. Likewise, the first end and the second end of the second electrode are opposite to one another. The first end of the first electrode and the first end of the second electrode are oriented towards each other. In other words, the first end of the first electrode and the first end of the second electrode are pointing to each other. Thus, in a situation in which the first electrode and the second electrode are subject to an electric voltage, an electric arc may occur between the first end of the first electrode and the first end of the second electrode. In other words, the electric arc may be formed in the gap between the first ends. Such an electric arc may be provoked between the first ends by choosing the electric voltage accordingly. Furthermore, the occurrence of the electric arc depends on an electric property of the environment in which the test device is used, more precisely on the material arranged between the first end of the first electrode and the first end of the second electrode and the material's electric properties. Also the size of the gap is a factor influencing the occurrence of the electric arc. Thus, the gap between the first ends of the electrodes may serve as a measuring section for an electric arcing property of the environment of the test device. If this environment is located inside a traction battery or adjacent to the traction battery, an electric arcing property of the traction battery may be evaluated. The test device itself is comparatively small and robust. Thus, it can be used multiple times in an environment in which electrical arcing happens.

It is noted that the test device may be positioned inside the vehicle or inside the traction battery of the vehicle. Alternatively, the test device may be positioned in a traction battery, wherein the traction battery is located outside the vehicle. In a further alternative, the test device may be positioned in a battery pack which is specifically configured for evaluating an electric arcing property. This battery pack does not need to be the same as the actual traction battery of the. In this case, the battery pack can be smaller than a traction battery of a vehicle. Yet, in other words, the test device may be used in test situations and/or test setups, where experiments are conducted to evaluate an electric arcing property of a battery, excluding a need of a vehicle or an actual traction battery. Still the test results produced using the test device may provide valuable insights that apply to the actual traction battery.

In an example, the holder comprises a base portion, a first side portion and a second side portion. The first side portion and the second side portion extend from opposite ends of the base portion into the same direction. The first electrode is supported on the first side portion and the second electrode is supported on the second side portion. Such a holder may be described as being U-shaped or C-shaped. This has the effect that the first ends of the electrodes may reliably be held at a distance from each other, thereby maintaining the gap between them. Further, the first electrode and the second electrode are not electrically connected to each other since the holder is non-conductive or electrically isolated.

The base portion and/or the first side portion and the second side portion may be made of the same material. Further, the base portion and/or the first side portion and the second side portion may be coated for achieving non-conductive or electrically insulated property. According to another example, the base portion, the first side portion and the second side portion are formed integrally. This allows to produce the holder in a particularly efficient manner.

In an example, the electrodes are arranged coaxially. This means that the first electrode and the second electrode are aligned on an common or shared axis. This has the effect that the gap between the first ends of the electrodes is the shortest distance between the electrodes. Thus, electric arcing will start between the first ends of the electrodes. This ensures that the gap between the first ends of the electrodes reliably serves as a measuring section for an electric arcing property in between them.

In an example, the first electrode has a substantially circular cross section. Additionally or alternatively, the second electrode has a substantially circular cross section. The first electrode and/or the second electrode may comprise a cylindrical shape. Consequently, the first electrode and/or the second electrode is formed in a structurally simple manner. Optionally, a thread can be formed on the first electrode and/or the second electrode. Consequently, the first and/or the second electrode can be screwed into the first side portion and/or the second side portion, respectively. In such a configuration a width of a gap between the first end of the first electrode and the first end of the second electrode may be easily and quickly adjusted.

In an example, the first end of the first electrode is tapered. Additionally or alternatively, the first end of the second electrode is tapered. When an electric voltage is applied to the electrodes, this leads to a defined concentration of an electric field at the tips tapered ends. Thus, the potential of electric arcing occurring between the two electrodes may be further enhanced.

In an example, the first electrode comprises an insulation means arranged between the first end and the second end of the first electrode. Additionally or alternatively, the second electrode comprises an insulation means arranged between the first end and the second end of the second electrode. This implies that the first ends and the second ends do not comprise insulation means. Both second ends may be configured to be connected to an electric source. The insulation means facilitate the handling of the first electrode and/or the second electrode and, thus, the test device as a whole. This is the case since less current-carrying portions of the test device are accessible for a user. Moreover, due to the insulation means, a risk for undesired malfunctions, e.g. electric arcs forming remote from the first ends of the electrodes, is reduced.

In an example, a maximum length or maximum width of the holder is inferior to 80 mm. This has the effect that the size of the holder is compact. Thus, the implementation of the holder in a traction battery and/or in a vehicle and/or in a battery pack smaller than a traction battery, e.g. forming part of a test setup, of a vehicle may be facilitated.

In an example, a width of the gap is adjustable. In other words, the distance between the first end of the first electrode and the first end of the second electrode may be varied. In case one or both electrodes comprise a thread, this may be accomplished by turning one or both of the electrodes relatively to the holder. An adjustable gap between the first ends of the electrodes has the effect that the electric arcing property can be evaluated at different widths of the gap, i.e. different distances between the first ends of the electrodes. Thus, the test device is adaptable to different test scenarios. Hence, an evaluation of the risk of electric arcing for parts of a traction battery can be made, wherein the parts are subject to an electric voltage and are located at different distances.

According to a second aspect, there is provided a test system for evaluating an electric arcing property of a traction battery of a vehicle. The test system comprises a test device according to the present disclosure, an electric source, and an electric monitoring unit. The electric source is electrically connected to the second end of the first electrode and to the second end of the second electrode such that a voltage may be generated between the first end of the first electrode and the first end of the second electrode. The electric monitoring unit is electrically connected to the first electrode and to the second electrode such that an electric parameter indicative of an electric property of the gap between the first electrode and the second electrode may be monitored. In this context, the electric property of the gap corresponds to an electric property of the material located in the gap, e.g. air. The electric source is capable of subj ecting the first electrode and the second electrode to a voltage. The electric source may be adjustable such that different voltages may be provided. This facilitates the evaluation of an electric arcing property, since a defined voltage may be used. This defined voltage may be different in different test scenarios. According to an example, the generated voltage between the first electrode and the second electrode leads to an electric arcing between the electrodes. The electric monitoring unit allows to observe and evaluate an electric arcing property between the first electrode and the second electrode, i.e. the electric parameter may be monitored during arcing and an electric arcing property may be evaluated based thereon or derived therefrom.

It is noted that the electric source and the test device are electrically connected by isolated leads. In other words, both the second end of the first electrode and the second end of the second electrode are electrically connected to the electric source via isolated leads. This has the effect that an electric arcing between the leads or the leads and other parts of the test system may be avoided. Consequently, an electric arcing property of the gap between the first ends of the electrodes of the test device may be determined. The determined electric arcing property may serve as a basis for evaluating the electric arcing property of a traction battery of a vehicle.

In an example, the electric parameter is indicative of an electric resistance of the gap between the first electrode and the second electrode. The electric monitoring unit may comprise an ohmmeter.

The electric parameter indicative of an electric resistance may be determined directly or indirectly. In a case in which the electric parameter is determined indirectly, an electric voltage and an electric current may be monitored and a parameter indicative of an electric resistance may be calculated based thereon.. In other words, the electric parameter may be monitored using comparatively simple and robust means.. This has the effect that an evaluation of an electric arcing property may be achieved in an efficient manner.

In this context, an electric parameter indicative of electric voltage and/or an electric parameter indicative of electric current may be monitored directly. The electric monitoring unit may comprise a voltmeter and/or an ampere meter.

The electric parameter indicative of an electric resistance and/or the electric parameter indicative of an electric voltage and/or the electric parameter indicative of an electric current may be used for the assessment of a risk of electrical arcing, i.e. for evaluating an electric arcing property.

According to a third aspect, there is provided a use of a test device according to the present disclosure. The test device may be placed in an enclosure of the traction battery of the vehicle. Alternatively, the test device may be placed in an enclosure of a battery pack specifically designed for performing a test for evaluating an electric arcing property. Such a battery pack may be different from the battery pack actually used in an electric vehicle. In both alternatives, the electric arcing properties may be evaluated at a location corresponding to a location where usually electric arcing occurs or at least close thereto. Thus, the evaluation may be precise. The comparatively small size of the test device facilitates this evaluation. Moreover, such an evaluation is cost-efficient.

According to a fourth aspect, there is provided a use of a test system according to the present disclosure.. Such a test system allows for a precise and cost-efficient evaluation of electric arcing properties.

According to a fifth aspect, the present disclosure is directed to a method for evaluating an electric arcing property of a traction battery of a vehicle. The method comprises:
- providing a test device according to the present disclosure in an enclosure comprising at least one battery cell,
- generating a voltage between the first electrode and the second electrode using an electric source, wherein the electric source is separate from the at least one battery cell,
- causing the at least one battery cell to undergo a thermal event, and
- monitoring an electric parameter indicative of an electric property of the gap between the first electrode and the second electrode.

When executing the method, the test device according to the present disclosure may be used. The monitored electric parameter indicative of an electric property of the gap between the first electrode and the second electrode may correspond to an electric property of the traction battery of a vehicle. This is for example the case if that the traction battery comprises the same at least one battery cell. Consequently, using this method, electric arcing properties may be evaluated in a precise and cost-efficient way. Moreover, this method allows an observation and an evaluation of an electric arcing property with a relatively small amount of battery cells compared to all battery cells incorporated in a traction battery. Further, the method allows this evaluation without severely damaging the test device and/or the at least one battery cell and/or the enclosure. In addition, the method saves time and resources during evaluation of an electric arcing property of a traction battery of a vehicle.

Causing the at least one battery cell to undergo a thermal event may be done by one or more of
- heating the at least one battery cell using a heating element,
- arranging the at least one battery cell, the first electrode and the second electrode in an oven,
- charging the at least one battery cell using a charging unit, and/or
- discharging the at least one battery cell using a discharging unit.
All of these examples allow to reliably cause the at least one battery cell to undergo a thermal event.

In an example, the method further comprises varying a width of the gap. In other words, the distance between the first end of the first electrode and the first end of the second electrode may be varied. An adjustable gap between the first ends of the electrodes has the effect that the electric arcing property can be evaluated at different widths of the gap, i.e. different distances between the first ends of the electrodes. Thus, the method is adaptable to different test scenarios. Hence, an evaluation of the risk of electric arcing for parts of a traction battery can be made, wherein the parts are subject to an electric voltage and are located at different distances.

In an example, the method further comprises providing two or more test devices according to the present disclosure in the enclosure. This has the effect that more complex tests may be conducted. This is because two or more test devices may be positioned at different locations in the enclosure allowing simultaneously monitoring multiple electric parameters indicative of an electric property of the gap between the first electrode and the second electrode of each test device. For example, the electric arcing property may be evaluated close to a vent of the at least one battery cell. In another example, the electric arcing property may be evaluated close to an electric connection terminal of the battery cell.

Still in another example, a barrier may be placed in the enclosure. The battier may be configured to shield conductive gaseous and/or liquid electrolyte and/or solid matter. Thus, using the barrier, the enclosure may be separated into two portions, wherein conductive gaseous and/or liquid electrolyte and/or solid matter cannot travel from one of these portions into the other. Thus, effects of a thermal event may be restricted to one such portion. Moreover, in a case in which multiple test devices are used, the barrier can be used in order to reduce or eliminate mutual influences of the evaluations performed using the multiple test devices.

It should be noted that the above examples may be combined with each other irrespective of the aspect involved. Accordingly, the method may be combined with structural features and, likewise, the device and the system may be combined with features described above with regard to the method.

These and other aspects of the present disclosure will become apparent from and elucidated with reference to the examples described hereinafter.

### BRIEF DESCRIPTION OF DRAWINGS

Examples of the disclosure will be described in the following with reference to the following drawings.
- Figure 1: shows a test setup for evaluating an electric arcing property of a traction battery of a vehicle comprising a test device according to the present disclosure and a test system according to the present disclosure,
- Figure 2: shows the test device according to the present disclosure of the test system of Figure 1, and
- Figure 3: illustrates steps of a method according to the present disclosure for evaluating an electric arcing property of a traction battery of a vehicle.

### DETAILED DESCRIPTION

The Figures are merely schematic representations and serve only to illustrate examples of the disclosure. Identical or equivalent elements are in principle provided with the same reference signs.

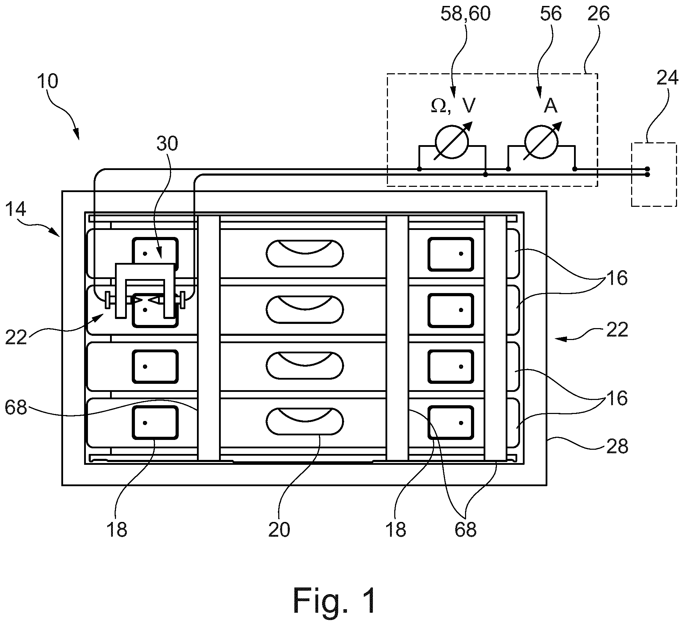

Figure 1 shows a test setup 10 for evaluating an electric arcing property of a traction battery 12 of a vehicle.

The test setup 10 comprises the traction battery 12 and a test system 14 for evaluating an electric arcing property of a traction battery 12 of a vehicle.

In the present example, the traction battery 12 comprises four battery cells 16 arranged in an enclosure 28. Of course, the traction battery 12 may also comprise a different number of battery cells 16. Such a traction battery 12 may for example be used in a hybrid electric vehicle. Alternatively, such a traction battery 12, comprising four battery cells 16 only, may be specifically designed and provided for performing tests, i.e. such a traction battery 12 may not be effectively used in a vehicle. In the latter case, the traction battery 12 may be imagined as a miniaturized version of the actual traction battery used in the vehicle.

Each battery cell 16 comprises two electric terminals 18 and one vent 20. The vent 20 may as well be designated as a degassing valve. For reasons of better readability, only the two electric terminals 18 and the vent 20 of one battery cell 16 are marked with a reference sign in Figure 1.

The test system 14 comprises a test device 22 for evaluating an electric arcing property of a traction battery 12 of a vehicle. The test system 14 further comprises an electric source 24 and an electric monitoring unit 26.

The test device 22 is placed inside the enclosure 28 of the traction battery 12.

It is noted that in the present example the test device 22 is positioned outside a vehicle. Since the test device 22 is used for test purposes, a vehicle must not be present.

In the present example, the test device 22 is placed near an electric terminal 18 of one of the battery cells 16.

The test device 22 comprises an electrically non-conductive holder 30.

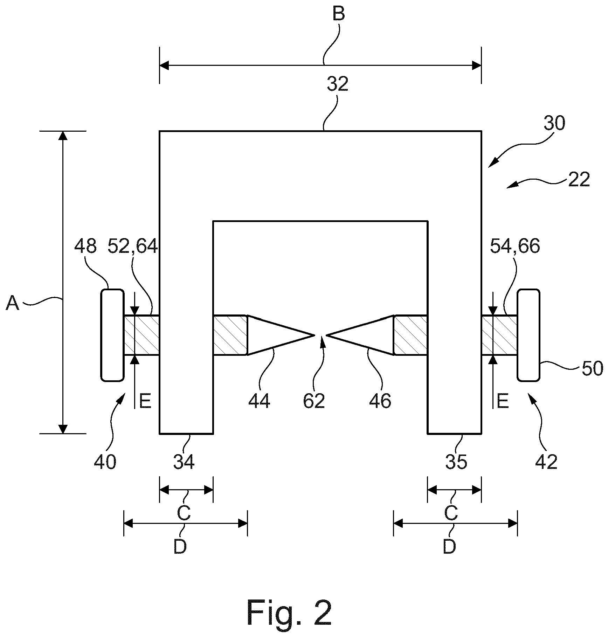

The holder 30 comprises a base portion 32 and two side portions 34, 35. The two side portions 34, 35 are arranged at opposite ends of the base portion 32 and, together with the base portion 32, resemble the shape of a "U". In the present example, the holder 30 has a width A and a length B of 70 mm (see Figure 2).

The two side portions 34, 35 each support an electrode 40, 42 of the test device 22. More precisely, the first side portion 34 supports a first electrode 40 and the second side portion 35 supports a second electrode 42. The two side portions 34, 35 each have a width C of 10 mm.

Both the first electrode 40 and the second electrode 42 are formed as bolts.

The first electrode 40 has a first end 44 and a second end 48. The first end 44 and the second end 48 are opposed to one another.

The second electrode 42 has a first end 46 and a second end 50. The first end 46 and the second end 50 are opposed to one another.

In the present example, the first ends 44, 46 of the electrodes 40, 42 are tapered.

At the second ends 48, 50 each of the first electrode 40 and the second electrode 42 comprises a connection head configured to electrically contact the electrodes 40, 42 as will be explained in more detail further below.

In between the first end 44 and the second end 48, the first electrode 40 has a a substantially cylindrical section 52. The second electrode 42 also has a substantially cylindrical section 54 between the first end 46 and the second end 50.

In the present example, a length D of the cylindrical section 52, 54 is 25 mm. A diameter E of the cylindrical section 52, 54 is 4 mm.

The first end of the first electrode 44 and the first end of the second electrode 46 are placed at a distance from each other. In other words, the first end of the first electrode 44 and the first end of the second electrode 46 form a gap 62 between each other. The gap 62 between the first ends 44, 46 is adjustable from 0 mm to 50 mm.

Further, both the first electrode 40and the second electrode 42 feature a thread (not shown). This means that the first electrode 40 and the second electrode 42 are screwed into the first side portion 34 and the second side portion 35 of the holder 30, respectively.

Due to the thread formed on each electrode 40, 42, the gap 62 formed between the first ends of the electrodes 44, 46 may be adjusted by turning one or both of the electrodes 40, 42.

To this end, the second end 48 of the first electrode 40 and the second end 50 of the second electrode 42 comprise an interface for mechanically engaging a tool, e.g. a wrench or an Allen key.

Additionally, both the first electrode 40 and the second electrode 42 comprise insulating means 64, 66 arranged between their respective first and second ends. Together with the tapered shape of the first ends 44, 46 of the electrodes, this prevents undesired arcs from forming between one of the electrodes 40, 42 and at least one of the battery cells 16.

The second end of the first electrode 48 and the second end of the second electrode 50 are connected to the electric source 24 via electrically insulated wires.

The test system 14 also comprises an ampere meter 56 which is connected to the electric connection line, i.e. the wire, extending from the second end of the first electrode 48 and the electric source 24.

Furthermore, an ohmmeter 58 and a voltmeter 60 are connected to both the electrically insulated wires.

It is understood that the electrical insulation of the wires is locally interrupted at the positions at which the ampere meter 56, the ohmmeter 58 and the voltmeter 60 are connected thereto..

The ampere meter 56, the ohmmeter 58 and the voltmeter 60 together form the electric monitoring unit 26.

When an electric voltage is applied to both electrodes 40, 42, this leads to a defined concentration of an electric field at the tapered first ends 44, 46.

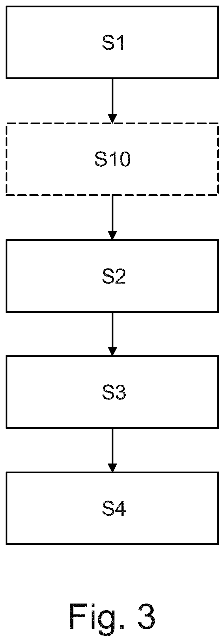

In the following, a method for evaluating an electric arcing property of a traction battery 12 of a vehicle will be explained in more detail in connection with Figure 3.

In a first step S1 of the method, the test device 22 is provided in the enclosure 28 of the traction battery 12.

Optionally, two or more test devices 22 according to the present disclosure may be provided in the enclosure 28. In this case, one or more optional barriers 68 may be used in order to separate the test devices 22 from one another. This ensures that the evaluations provided by the test devices 22 do not negatively affect one another. For example, a first test device 22 may be placed in a first area close to the electric terminal 18 of the at least one battery cell 16, and a second test device 22 (not shown) may be placed in a second area close to the vent 20 of the at least one battery cell 16. A third test device 22 may be placed in an area close to another electric terminal 18.

Further, in an optional step S10, the width of the gap 62 is varied. In doing so, the width of the gap 62 may be adjusted to the specific evaluation to be performed.

In a second step S2, the first electrode 40 and the second electrode 42 are subject to a voltage using the electric source 24. It is noted that the electric source 24 is separate from the battery cells 16. This means that the electric source 24 is not electrically connected to any of the battery cells 16.

In a third step S3, at least one of the battery cells 16 is caused to undergo a thermal event.

This causes the battery cell 16 that undergoes the thermal event to eject conductive gaseous and/or liquid electrolyte from its inside through the vent 20 of the battery cell 16. Additionally or alternatively, conductive solid matter may be ejected from the inside of the respective battery cell 16.

The gaseous and/or liquid electrolyte and/or solid matter affects an electric conductivity of the atmosphere inside the enclosure 28 of the traction battery 12. Since, in the present example, the test device 22 is placed inside the enclosure 28 of the traction battery 12, the electric conductivity of the gap 62 between the first ends of the electrodes 44, 46 is affected.

In the present example of the battery cell 16 undergoing a thermal event end ejecting conductive matter, the conductivity of the gap 62 between the first ends of the electrodes 44, 46 is increased. Since an inverse of the electric conductivity is an electric resistance, this means that an electric resistance of the gap 62 is decreased.

The higher the electric conductivity and the lower the electric resistance of the gap 62 between the first ends of the electrodes 44, 46 get, the higher the risk for an electric arc to form between the first ends of the electrodes 44, 46.

Thus, depending on the voltage to which the first electrode 40 and the second electrode 42 are subject, an electric arc may occur between the first ends 44, 46.

In a fourth step S4, the electric parameter indicative of an electric property of the gap 62 between the first electrode 40 and the second electrode 42 is monitored. For the monitoring, the electric monitoring unit 26 is used. In this context, the electric parameter indicative of an electric property of the gap 62 between the first electrode 40 and the second electrode 42 is an electric voltage, an electric current, and an electric resistance.

More precisely, the ampere meter 56 determines an amount of electric current flowing between the first ends 44, 46 of the electrodes 40, 42.

The ohmmeter 58 determines an electric resistance of the gap 62 between the first ends 44, 46 of the two electrodes 40, 42.

The voltmeter 60 determines a value of the electric voltage between the electrodes 40, 42.

These parameters describe an electric arcing property. This is the case if an electric arc occurs between the first ends 44, 46. The same is true if no electric arc occurs because also in such a situation, these parameters change due to the thermal event.

As used herein, the phrase "at least one" in reference to a list of one or more entities should be understood to mean at least one entity selected from any one or more of the entities in the list of entities, but not necessarily including at least one of each and every entity specifically listed within the list of entities and not excluding any combinations of entities in the list of entities. This definition also allows that entities may optionally be present other than the entities specifically identified within the list of entities to which the phrase "at least one" refers, whether related or unrelated to those entities specifically identified. Thus, as a non-limiting example, "at least one of A and B" (or, equivalently, "at least one of A or B," or, equivalently "at least one of A and/or B") may refer, in one example, to at least one, optionally including more than one, A, with no B present (and optionally including entities other than B); in another example, to at least one, optionally including more than one, B, with no A present (and optionally including entities other than A); in yet another example, to at least one, optionally including more than one, A, and at least one, optionally including more than one, B (and optionally including other entities). In other words, the phrases "at least one," "one or more," and "and/or" are open-ended expressions that are both conjunctive and disjunctive in operation. For example, each of the expressions "at least one of A, B, and C," "at least one of A, B, or C," "one or more of A, B, and C," "one or more of A, B, or C," and "A, B, and/or C" may mean A alone, B alone, C alone, A and B together, A and C together, B and C together, A, B, and C together, and optionally any of the above in combination with at least one other entity.

Other variations to the disclosed examples can be understood and effected by those skilled in the art in practicing the claimed disclosure, from the study of the drawings, the disclosure, and the appended claims. In the claims the word "comprising" does not exclude other elements or steps and the indefinite article "a" or "an" does not exclude a plurality. A single processor or other unit may fulfill the functions of several items or steps recited in the claims. The mere fact that certain measures are recited in mutually different dependent claims does not indicate that a combination of these measures cannot be used to advantage. A computer program may be stored/distributed on a suitable medium such as an optical storage medium or a solid-state medium supplied together with or as part of other hardware, but may also be distributed in other forms, such as via the Internet or other wired or wireless telecommunication systems. Any reference signs in the claims should not be construed as limiting the scope of the claims.

### LIST OF REFERENCE SIGNS

- 10: test setup
- 12: traction battery
- 14: test system
- 16: battery cell
- 18: electric terminal
- 20: vent
- 22: test device
- 24: electric source
- 26: electric monitoring unit
- 28: enclosure
- 30: holder
- 32: base portion
- 34: first side portion
- 35: second side portion
- 40: first electrode
- 42: second electrode
- 44: first end of first electrode
- 46: first end of second electrode
- 48: second end of first electrode
- 50: second end of second electrode
- 52: substantially circular section of first electrode
- 54: substantially circular section of second electrode
- 56: ampere meter
- 58: ohmmeter
- 60: voltmeter
- 62: gap
- 64: insulating means of first electrode
- 66: insulating means of second electrode
- 68: barrier

- A: width of holder
- B: length of holder
- C: width of side portion
- D: length of cylindrical section
- E: diameter of cylindrical section

- S1: first step
- S2: second step
- S3: third step
- S4: fourth step
- S10: optional step

## Claims

1. A test device (22) for evaluating an electric arcing property of a traction battery (12) of a vehicle, the test device (22) comprising an electrically non-conductive or electrically insulated holder (30), a first electrode (40) having a first end (44) and a second end (48), and a second electrode (42) having a first end (46) and a second end (50),
wherein the first electrode (40) and the second electrode (42) are supported on the holder (30) such that the first end (44) of the first electrode (40) and the first end (46) of the second electrode (42) form a gap (62) between each other.

2. The test device (22) of claim 1, wherein the holder (30) comprises a base portion (32), a first side portion (34) and a second side portion (35), wherein the first side portion (34) and the second side portion (35) extend from opposite ends of the base portion (32) into the same direction, and wherein the first electrode (40) is supported on the first side portion (34) and the second electrode (42) is supported on the second side portion (35).

3. The test device (22) of claim 1 or 2, wherein the first electrode (40) and the second electrode (42) are arranged coaxially.

4. The test device (22) of any one of the preceding claims, wherein the first electrode (40) and/or the second electrode (42) has a substantially circular cross section.

5. The test device (22) of any one of the preceding claims, wherein the first end (44) of the first electrode (40) and/or the first end (46) of the second electrode (42) is/are tapered.

6. The test device (22) of any one of the preceding claims, wherein the first electrode (40) comprises an insulation means (64) arranged between the first end (44) and the second end (48) of the first electrode (40) and/or wherein the second electrode (42) comprises an insulation means (66) arranged between the first end (46) and the second end (50) of the second electrode (42).

7. The test device (22) of any one of the preceding claims, wherein a maximum length (B) or maximum width (A) of the holder (30) is inferior to 80 mm.

8. The test device (22) of any one of the preceding claims, wherein a width of the gap (62) is adjustable.

9. A test system (14) for evaluating an electric arcing property of a traction battery (12) of a vehicle, the test system (14) comprising a test device (22) according to any one of the preceding claims, an electric source (24), and an electric monitoring unit (26), wherein the electric source (24) is electrically connected to the second end of the first electrode (48) and to the second end of the second electrode (50) such that a voltage may be generated between the first end of the first electrode (44) and the first end of the second electrode (46), and
wherein the electric monitoring unit (26) is electrically connected to the first electrode (40) and to the second electrode (42) such that an electric parameter indicative of an electric property of the gap (62) between the first electrode (40) and the second electrode (42) may be monitored.

10. The test system (14) of claim 9, wherein the electric parameter is indicative of an electric resistance of the gap (62) between the first electrode (40) and the second electrode (42).

11. A use of a test device (22) of any one of claims 1 to 8 and/or a test system (14) of claim 9 or 10 for evaluating an electric arcing property of a traction battery (12) of a vehicle.

12. A method for evaluating an electric arcing property of a traction battery (12) of a vehicle, the method comprising:
- providing a test device (22) according to any one of claims 1 to 8 in an enclosure (28) comprising at least one battery cell (16),
- generating a voltage between the first electrode (40) and the second electrode (42) using an electric source (24), wherein the electric source (24) is separate from the at least one battery cell (16),
- causing the at least one battery cell (16) to undergo a thermal event, and
- monitoring an electric parameter indicative of an electric property of the gap (62) between the first electrode (40) and the second electrode (42).

13. The method of claim 12, further comprising varying a width of the gap (62).

14. The method of claim 12 or 13, further comprising providing two or more test devices (22) according to any one of claims 1 to 8 in the enclosure (28).

## Amended claims

### Amended claims in accordance with Rule 137(2) EPC.

1. A test system (14) for evaluating an electric arcing property of a traction battery (12) of a vehicle, the test system (14) comprising a test device (22), an electric source (24), and an electric monitoring unit (26),
the test device (22) comprising an electrically non-conductive or electrically insulated holder (30), a first electrode (40) having a first end (44) and a second end (48), and a second electrode (42) having a first end (46) and a second end (50),
wherein the first electrode (40) and the second electrode (42) are supported on the holder (30) such that the first end (44) of the first electrode (40) and the first end (46) of the second electrode (42) form a gap (62) between each other,
wherein the electric source (24) is electrically connected to the second end of the first electrode (48) and to the second end of the second electrode (50) such that a voltage may be generated between the first end of the first electrode (44) and the first end of the second electrode (46), and
wherein the electric monitoring unit (26) is electrically connected to the first electrode (40) and to the second electrode (42) such that an electric parameter indicative of an electric property of the gap (62) between the first electrode (40) and the second electrode (42) may be monitored.

2. The test system (14) of claim 1, wherein the electric parameter is indicative of an electric resistance of the gap (62) between the first electrode (40) and the second electrode (42).

3. The test system (14) of claim 1 or 2, wherein the holder (30) comprises a base portion (32), a first side portion (34) and a second side portion (35), wherein the first side portion (34) and the second side portion (35) extend from opposite ends of the base portion (32) into the same direction, and wherein the first electrode (40) is supported on the first side portion (34) and the second electrode (42) is supported on the second side portion (35).

4. The test system (14) of any of the preceding claims, wherein the first electrode (40) and the second electrode (42) are arranged coaxially.

5. The test system (14) of any of the preceding claims, wherein the first electrode (40) and/or the second electrode (42) has a substantially circular cross section.

6. The test system (14) of any of the preceding claims, wherein the first end (44) of the first electrode (40) and/or the first end (46) of the second electrode (42) is/are tapered.

7. The test system (14) of any of the preceding claims, wherein the first electrode (40) comprises an insulation means (64) arranged between the first end (44) and the second end (48) of the first electrode (40) and/or wherein the second electrode (42) comprises an insulation means (66) arranged between the first end (46) and the second end (50) of the second electrode (42).

8. The test system (14) of any of the preceding claims, wherein a maximum length (B) or maximum width (A) of the holder (30) is inferior to 80 mm.

9. The test system (14) of any of the preceding claims, wherein a width of the gap (62) is adjustable.

10. A use of a test system (14) of any one of claims 1 to 9 for evaluating an electric arcing property of a traction battery (12) of a vehicle.

11. A method for evaluating an electric arcing property of a traction battery (12) of a vehicle, the method comprising:
- providing a test device (22) in an enclosure (28) comprising at least one battery cell (16), the test device (22) comprising an electrically non-conductive or electrically insulated holder (30), a first electrode (40) having a first end (44) and a second end (48), and a second electrode (42) having a first end (46) and a second end (50),
wherein the first electrode (40) and the second electrode (42) are supported on the holder (30) such that the first end (44) of the first electrode (40) and the first end (46) of the second electrode (42) form a gap (62) between each other,
- generating a voltage between the first electrode (40) and the second electrode (42) using an electric source (24), wherein the electric source (24) is separate from the at least one battery cell (16),
- causing the at least one battery cell (16) to undergo a thermal event, and
- monitoring an electric parameter indicative of an electric property of the gap (62) between the first electrode (40) and the second electrode (42).

12. The method of claim 11, further comprising varying a width of the gap (62).

13. The method of claim 11 or 12, further comprising providing two or more test devices (22) in the enclosure (28), wherein each of the two or more test devices comprise an electrically non-conductive or electrically insulated holder (30), a first electrode (40) having a first end (44) and a second end (48), and a second electrode (42) having a first end (46) and a second end (50),
wherein the first electrode (40) and the second electrode (42) are supported on the holder (30) such that the first end (44) of the first electrode (40) and the first end (46) of the second electrode (42) form a gap (62) between each other.
